# EUROPEAN PATENT APPLICATION

(11) **EP 4 800 414 A1**
(43) Date of publication of application: **02.09.2026**
(21) Application number: 26156139.3
(22) Date of filing: 03.02.2026
(51) Int. Cl.: G01R 33/09

(54) **A MAGNETIC MULTI-TURN SENSOR**

(30) Priority: 28.02.2025 US 202563765100 P
(71) Applicant: Analog Devices International Unlimited Company, Co. Limerick (IE)
(72) Inventor: KUBIK, Jan, Co. Limerick (IE); SCHMITT, Jochen, Co. Limerick (IE); TEICHERT, Niclas, Co. Limerick (IE); MATTHEIS, Roland, 07743 Jena (DE)
(74) Representative: Halliwell, Bethan Frances

(57) **Abstract**

The present disclosure provides a magnetic multi-turn sensor having a length of magnetoresistive film, wherein the magnetoresistive film comprises a free layer of ferromagnetic material. The free-layer of ferromagnetic material has at least one region of increased thickness, relative to a thickness of the free-layer along the rest of the length of magnetoresistive film. In particular, the free layer is provided with an increased thickness in regions where an increased operating window is required. For example, in closed loop sensors, the points in which two section of magnetoresistive film cross (e.g., to close the loop) may require a higher magnetic operating window to prevent domain wall nucleation in that region.

## Description

### Field of Disclosure

The present disclosure relates to magnetic multi-turn sensors. In particular, the present disclosure relates to a magnetic multi-turn sensor comprising a magnetoresistive film having a free layer, in which the free layer has an increased thickness in at least one region.

### Background

Magnetic multi-turn sensors are commonly used in applications where there is a need to monitor the number of times a device has been turned. An example is a steering wheel in a vehicle. Magnetic multi-turn sensors typically include magnetoresistance elements that are sensitive to an applied external magnetic field. The resistance of the magnetoresistance elements can be changed by rotating a magnetic field within the vicinity of the sensor. Variations in the resistance of the magnetoresistance elements can be tracked to determine the number of turns in the magnetic field, which can be translated to a number of turns in the device being monitored.

Magnetic multi-turn sensors typically comprise a plurality of magnetoresistive elements laid out as a strip in an open-ended spiral or closed loop configuration. The magnetoresistive elements are typically formed from a magnetoresistive film that includes a layer of ferromagnetic material, referred to as a free layer, that changes its magnetization direction in response to an external magnetic field so as to provide the change in resistance.

### Summary

The present disclosure provides a magnetic multi-turn sensor having a length of magnetoresistive film, wherein the magnetoresistive film comprises a free layer of ferromagnetic material. The free-layer of ferromagnetic material has at least one region of increased thickness, relative to a thickness of the free-layer along the rest of the length of magnetoresistive film. In particular, the free layer is provided with an increased thickness in regions where an increased operating window is required. For example, in closed loop sensors, the points in which two section of magnetoresistive film cross (e.g., to close the loop) may require a higher magnetic operating window to prevent domain wall nucleation in that region.

Further features and embodiments of the disclosure are provided in the appended aspects.

### Brief Description of the Drawings

The present disclosure will now be described by way of example only with reference to the accompanying drawings in which:
Figures 1A-B illustrate examples of a magnetic multi-turn sensor according to the present disclosure;
Figure 2 is a graph illustrating the relationship between free layer thickness and measurable resistance change;
Figures 3A-C illustrate examples of part of a magnetic multi-turn sensor according to the present disclosure;
Figures 4A-B illustrate examples of a magnetoresistive film according to the present disclosure;
Figure 5 illustrates part of a magnetic multi-turn sensor with increased free layer thickness according to the present disclosure;
Figure 6 is a graph illustrating the change in nucleation field for varying free layer thickness;
Figures 7A-B further illustrate part of a magnetic multi-turn sensor with increased free layer thickness according to the present disclosure;
Figure 8 is a graph further illustrating the change in nucleation field for varying free layer thickness;
Figure 9 is a graph further illustrating the change in nucleation field for varying free layer thickness;
Figure 10 is a graph illustrating the change in depinning field for varying free layer thickness;
Figure 11 is a graph further illustrating the change in depinning field for varying free layer thickness;
Figures 12A-B illustrate further examples of a magnetic multi-turn sensor according to the present disclosure;
Figure 13 illustrates a further example of a magnetic multi-turn sensor according to the present disclosure;
Figure 14 illustrates an example of reference resistor for use in a magnetic multi-turn sensor according to the present disclosure;
Figures 15A-D further illustrate the reference resistor shown in Figure 14;
Figures 16A-B illustrates examples of a free layer with increased thickness according to the present disclosure;
Figure 17 further illustrates an example of a free layer with increased thickness according to the present disclosure;
Figures 18A-D further illustrate examples of a free layer with increased thickness according to the present disclosure;
Figure 19 illustrates a further example of reference resistor for use in a magnetic multi-turn sensor according to the present disclosure;
Figure 20 illustrates a further example of part of a magnetic multi-turn sensor with increased free layer thickness according to the present disclosure;
Figure 21 illustrates a further example of a magnetoresistive film according to the present disclosure;
Figures 22A-B illustrate further examples of a magnetoresistive film according to the present disclosure;
Figures 23A-F illustrate an example of a method of manufacturing a magnetoresistive film according to the present disclosure;
Figure 24 illustrates a further example of a magnetoresistive film according to the present disclosure;
Figure 25 illustrates a further example of a magnetoresistive film according to the present disclosure;
Figure 26 illustrates a further example of a magnetoresistive film according to the present disclosure;
Figure 27A-B illustrate further examples of a magnetoresistive film according to the present disclosure;
Figure 28 illustrates a further example of a magnetoresistive film according to the present disclosure;
Figure 29 illustrates a further example of a magnetoresistive film according to the present disclosure.

### Detailed Description

Magnetic multi-turn sensors can be used to monitor the turn count of a rotating shaft. To do this, a magnet is typically mounted to the end of the rotating shaft, the multi-turn sensor being sensitive to the rotation of the magnetic field as the magnet rotates with the shaft. Such magnetic sensing can be applied to a variety of different applications, such as automotive applications, medical applications, industrial control applications, consumer applications, and a host of other applications which utilize information regarding a position of a rotating component.

Magnetic multi-turn sensors typically include giant magnetoresistive (GMR) elements or tunnel magnetoresistive (TMR) elements formed from a magnetoresistive film that is sensitive to an applied external magnetic field. The magnetoresistive elements may be arranged in a spiral or closed loop configuration. As an external magnetic field rotates, it causes domain walls to propagate through the magnetoresistive elements, which change the magnetic alignment of each magnetoresistive element as it passes through. The resistance of the magnetoresistive elements change as the magnetic alignment changes, the variations in the resistance being tracked to determine the number of turns in the magnetic field.

The present disclosure provides a magnetic multi-turn sensor having a length of magnetoresistive film, wherein the magnetoresistive film comprises a free layer of ferromagnetic material. The free-layer of ferromagnetic material has at least one region of increased thickness, relative to a thickness of the free-layer along the rest of the length of magnetoresistive film. In particular, the free layer is provided with an increased thickness in regions where an increased operating window is required. For example, in closed loop sensors, the points in which two section of magnetoresistive film cross (e.g., to close the loop) may require a higher magnetic operating window to prevent domain wall nucleation in that region.

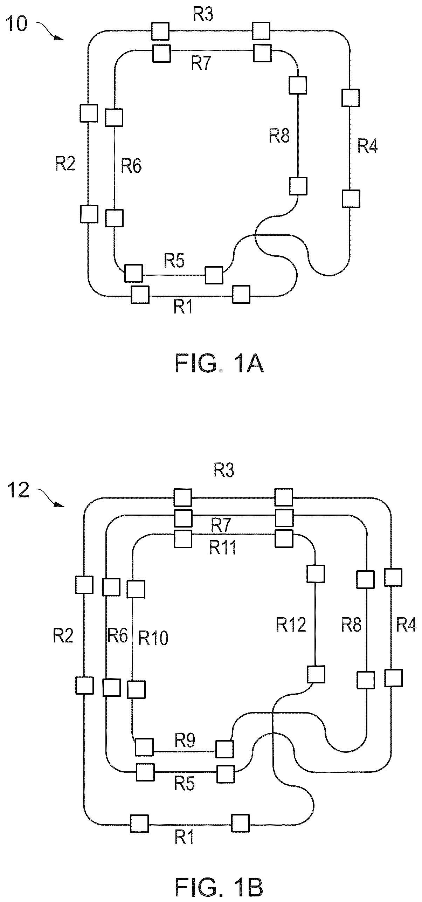

Figures 1A and 1B illustrate examples of magnetic multi-turn sensors into which embodiments of the present disclosure may be incorporated. Figure 1A shows a first closed loop sensor 10 comprising a track of magnetoresistive film, which may be a GMR film or a TMR film, arranged in a closed-loop spiral configuration. The sensor 10 comprises a plurality of electrical contacts that define a plurality of magnetoresistive sensing elements (R1-R8) connected in series, which can be connected to a power supply (not shown) to enable their resistances to be measured. As such, each arm of the spiral provides a magnetoresistive sensing element R1-R8 that changes resistance in response to a change in magnetic alignment state in the presence of an externally applied magnetic field. It will of course be appreciated that the magnetoresistive elements R1-R8 may be connected in any suitable way, for example, in a Wheatstone bridge arrangement, or in a matrix arrangement such as that described in German Publication No. DE102017104551A1 and US Publication No. 2017/261345, the contents of which are hereby incorporated by reference herein in their entirety. The outer and inner arms of the spiral (i.e., sensing elements R1 and R8) are connected such that a section of the magnetoresistive track crosses another section of the magnetoresistive track (i.e., between sensing elements R4 and R5).

Figure 1B provide a further example of a closed-loop multi-turn sensor 12 similar to that shown in Figure 1B, however, in this example, there is an additional loop of the magnetoresistive film, such that there are twelve magnetoresistive elements R1-R12, with the inner and outer arms of the spiral (i.e., sensing elements R1 and R12) being connected such that a section of the magnetoresistive track crosses over two furthers sections of the magnetoresistive track (i.e., between sensing elements R4 and R5, and between R8 and R9).

Both open and closed loop multi-turn sensors have a magnetic operating window, which defines the lower limit, Bmin, and the upper limit, Bmax, of the magnetic field strength in which the sensor will reliably operate. Magnetic field strengths below the lower limit, Bmin, will not be strong enough to trigger domain wall propagation and will cause domain walls to become stuck at pinning sites, thus causing the turn count information to become corrupted (e.g., no turns may be counted even if the external magnetic field has rotated). Conversely, magnetic field strengths above the upper limit, Bmax, can cause unwanted and premature domain wall nucleation, which can in turn result in an incorrect turn count (e.g., the sensor read out may show a higher number of turns than there has actually been).

A problem with current multi-turn sensors is that they often have a limited magnetic operating window, which can limit the applications in which they can be used, and make them more easily susceptible to faults, particularly in systems where there may be stray magnetic fields that increase the magnetic flux density in proximity to the sensor above the upper limit, Bmax of the operating window.

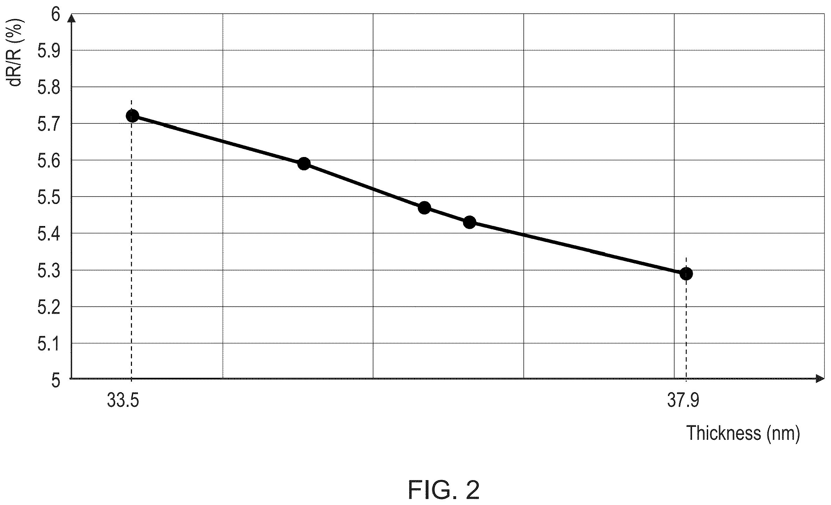

It has been found that a thicker free layer within the magnetoresistive film can increase the range of the magnetic operating window. However, increasing the thickness of the free layer can significantly reduce the measurable change of resistance, as illustrated by Figure 2. As can be seen from Figure 2, the measured change in resistance in an external magnetic field drops with increasing thickness of the free layer. Apart from the effect on change of resistance, an increased free layer can also result in an increase in some parasitic effects, which may also reduce the useful signal to noise ratio of the sensor.

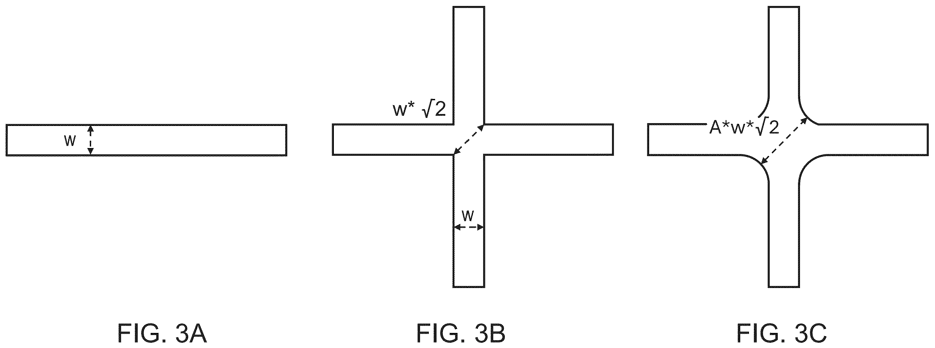

As discussed above with respect to Figures 1A-1B, the turn count of a multi-turn sensor is determined by the change of resistance measured along the magnetoresistive sensing elements (i.e., R1-R12), and thus a reduction in the measurable change of resistance in these regions cannot be tolerated. However, the areas in which the magnetoresistive track crosses over itself represent areas with a locally decreased domain wall nucleation field, Bnuc. It will of course be understood that the nucleation field Bnuc will substantially correspond to the upper limit, Bmax, of the magnetic operating window. That is to say, the Bnuc in these areas is lower, and thus domain wall nucleation can occur at lower magnetic fields compared to the rest of the sensor. This is illustrated by Figures 3A-C. Figure 3A shows a single track of magnetoresistive film having a width, ***w*,** wherein the Bnuc will be determined based on the width of the track. Figure 3B shows an ideal crossing of two magnetoresistive tracks, wherein the width of the crossing is calculated as the width **w** multiplied by √2. As such, the Bnuc will be lower approximately by a factor of √2 compared to the single track shown in Figure 3A. In reality, the arrangement shown in Figure 3B is impossible to fabricate, and most lithography processes will produce something similar to that shown in Figure 3C. Here, the width of the crossing is defined as ***A*** multiplied by ***w***√2, wherein ***A*** is the ratio between ideal width (as shown in Figure 3B) and fabricated width (as shown in Figure 3C). As such, the Bnuc will be lower by a factor of ***A***√2 compared to the single track shown in Figure 3A.

As such, one solution to increase the upper limit of the operating window in these crossings, without reducing the measurable change of resistance in the rest of the sensor, is to use a varying thickness of free layer within the sensor. The present disclosure therefore proposes the use of a thicker free layer in selected regions of a magnetic multi-turn sensor, for example, in regions that are more susceptible to domain wall pinning and nucleation, and which do not form part of the sensor readout.

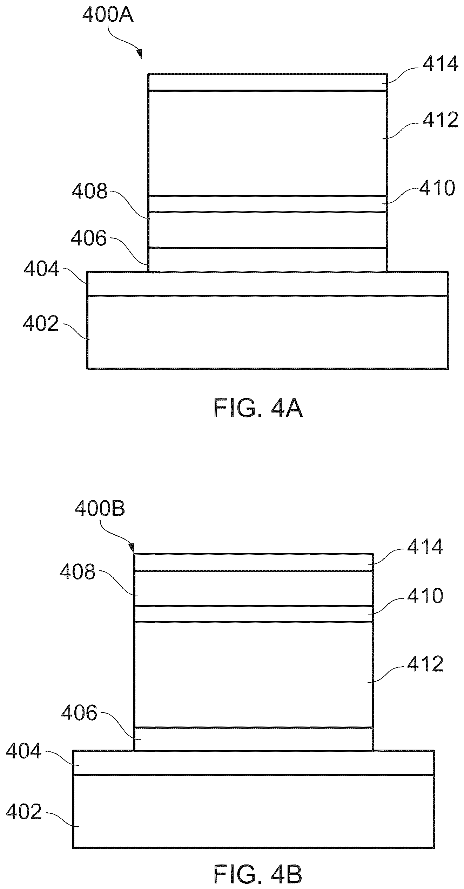

Figures 4A and 4B illustrate examples of a magnetoresistive film comprising a free layer of increased thickness.

Figure 4A illustrates an example of a magnetoresistive film 400A in which the "pinned" layer is below the free layer. The film 400A comprises a substrate 402 at the base, which may then be followed by a further base layer 404. For example, the substrate 402 may be formed from a silicon material, whilst the further base layer 404 may be formed from a silicon dioxide material. In this respect, the further base layer 404 acts as an insulating layer between the substrate 402, which may have conductive properties, and the rest of the magnetoresistive film to thereby prevent short circuiting of the sensing elements once the multi-turn sensor is electrically connected. This is then followed by a seed layer 406 for promoting growth of the following layers by providing a smooth surface and a favorable crystal structure on which to grow. The next layer is a synthetic antiferromagnetic (SAF) layer 408 comprising a sequence of layers that consist of two or more ferromagnetic layers (e.g., cobalt iron (CoFe)) separated by a non-magnetic spacer (e.g., ruthenium (Ru)). At least one of the ferromagnetic layers of the SAF layer 408 has a fixed magnetization direction, and is referred to as the "pinned" layer. The main purpose of the SAF layer 408 is to keep the magnetization of the pinned layer aligned in the fixed direction. It will also be appreciated that the SAF layer 408 may instead be an artificial antiferromagnetic (AFF) layer comprising a natural antiferromagnetic layer (such as platinum manganese (PtMn) or iridium manganese (IrMn)), a ferromagnetic layer (e.g. CoFe), a non-magnetic spacer (e.g.,Ru) and another ferromagnetic layer (e.g., CoFe) as the "pinned" layer. A non-magnetic spacer layer 410 (typically a metal such as copper (Cu) in a GMR film, or an oxide such as magnesium oxide (MgO) or aluminium oxide (Al2O3) in a TMR film) is provided directly on top of the pinned layer of the SAF layer 408, followed by the so-called free layer 412. The free layer 412 is a ferromagnetic layer free to align its magnetization with an external magnetic field. The free layer 412 is typically formed of two or more ferromagnetic layers, typically a CoFe layer followed by a nickel iron (NiFe) layer, though it will be appreciated that the free layer 412 may have any suitable arrangement. The xMR effect is observed as a change of film resistance associated with the relative angle between the magnetization of the free layer 412 and the magnetization of the pinned layer in the SAF layer 408. When the magnetizations are parallel, a low resistance is observed, and when anti-parallel, a high resistance is observed. The purpose of the non-magnetic layer 410 is thus to create a distance between the free layer 412 and the pinned layer, and the thickness of this spacer layer 410 will be chosen so that the magnetic coupling between the pinned layer and the free layer 412 is minimised. The film 400A is then usually topped with a capping layer 414 typically a non-magnetic metal layer, which protects the film 400A and reduces diffusions when connecting the film 400A to other metal layers (such as aluminium, copper or gold) in order to provide interconnects for connecting the film 400A to other components of the magnetic sensor.

Figure 4B illustrates an example of a magnetoresistive film 400B in which the "pinned" layer is above the free layer. In this respect, all of the layers of the magnetoresistive film 400B are the same as those in the magnetoresistive film 400A of Figure 4A, and thus the same references are used for clarity. However, in the example of Figure 4B, it can be seen that the free layer 412 is formed on the seed layer 406, followed by the non-magnetic spacer 410 and then the SAF layer 408. As such, the arrangement shown in Figure 4A is sometimes referred to as a "bottom pinned" magnetoresistive film, whilst the arrangement shown in Figure 4B is sometimes referred to as a "top pinned" magnetoresistive film.

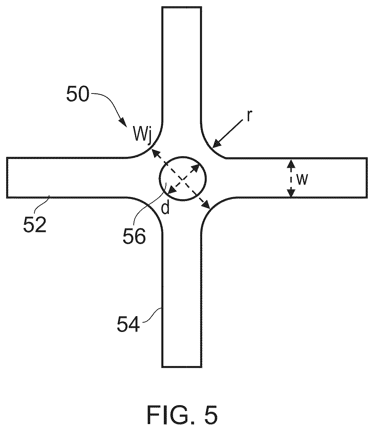

As described above, the present disclosure relates to a multi-turn sensor wherein the free layer of the magnetoresistive film has an increased thickness in some regions of the sensor, such as in regions where sections of the magnetoresistive film cross over. Figure 5 illustrates an example of a crossing 50 in which two sections of magnetoresistive film 52, 54 overlap, wherein a central area (shown generally at 56) of the crossing 50 has a free layer of increased thickness. In this example, the crossing 50 has a diameter **Wⱼ** and corners with a radius **r,** and the area 56 of increased thickness has a substantially circular configuration with a diameter ***d*.**

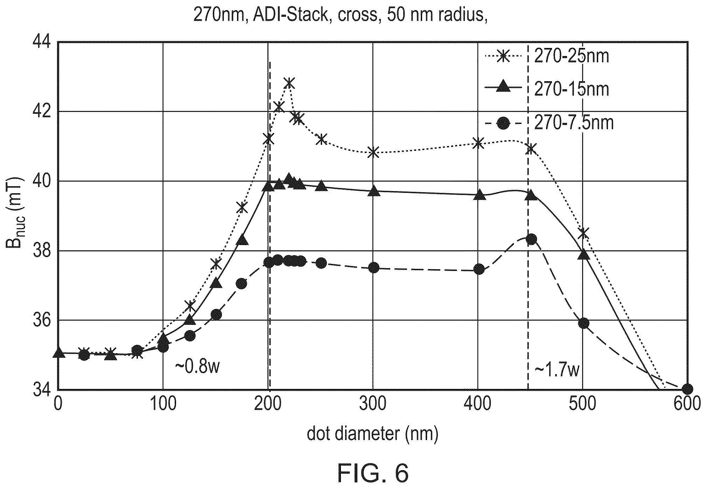

Figure 6 is a graph showing the change in the nucleation field, Bnuc, as the dimensions of the area 56 are varied, specifically, the thickness of the free-layer and the diameter of the area. More specifically, Figure 6 illustrates the Bnuc for an area 56 having a thickness of additional free layer of 7.5nm, an area 56 having a thickness of additional free layer of 15nm, and an area 56 having a thickness of additional free layer of 25nm, and how the Bnuc changes for each thickness as the diameter of the area 56 is increased. As can be seen, the Bnuc is increased with increased thickness, with the optimum range of diameters being between about 0.8w and 1.7w, wherein w is the width of the magnetoresistive track.

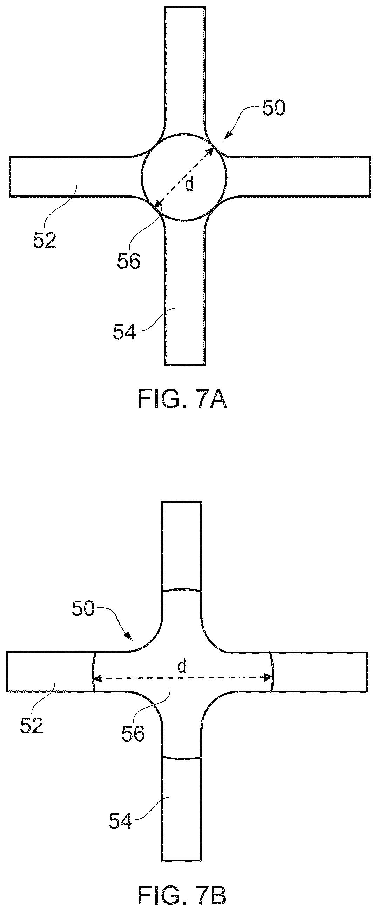

Figures 7A-B illustrate how the diameter of the area 56 shown in Figure 5 may be increased. In this respect, Figure 5 can be understood to show an area 56 with a diameter of around 0.8w. In Figure 7A, the diameter of the area 56 has been increased to approximately 1.7w. In Figure 7B, the diameter of the area 56 has been increased to approximately 7.5w.

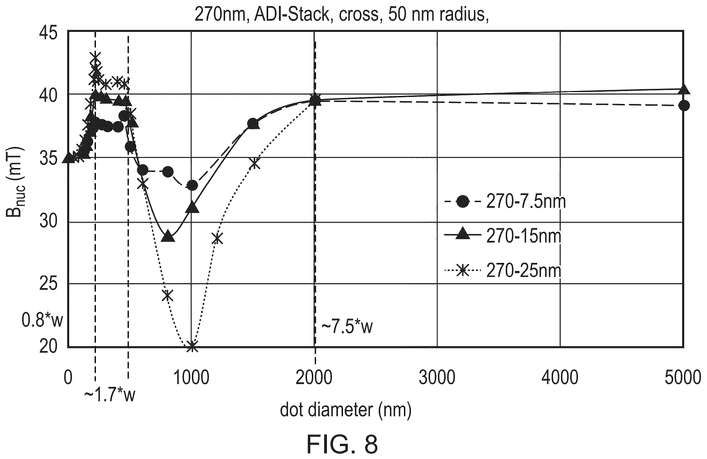

Figure 8 further illustrates the nucleation field, Bnuc, for areas having a varying free layer thickness and diameter. As can be seen, a useful increase in Bnuc is achieved for an area diameter of between 0.8w (i.e., as shown in Figure 5) and 1.7w (i.e., as shown in Figure 7A), or an area diameter above 7.5w (i.e., as shown in Figure 7B). For larger area diameters, the Bnuc reaches a saturation level, such that the Bnuc corresponds to the Bnuc value for a magnetoresistive film with homogenous thickness increase (i.e., no local thickness increase). That is to say, above 7.5w, no further increase in Bnuc is experienced if the area of increased free layer thickness is increased further.

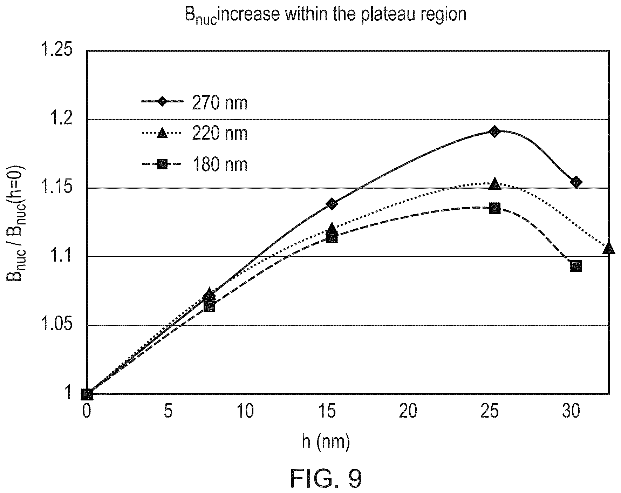

Figure 9 illustrates the optimal increase in the thickness of the free layer in order to the increase the nucleation field, Bnuc. For magnetoresistive tracks having a width between 180nm and 270nm, an increase of around 20nm provides the required increase in Bnuc. In this respect, a total thickness of the free layer of about 60nm provides the highest Bnuc, that is to say, increasing the free layer thickness beyond this does not provide further improvements in the Bnuc.

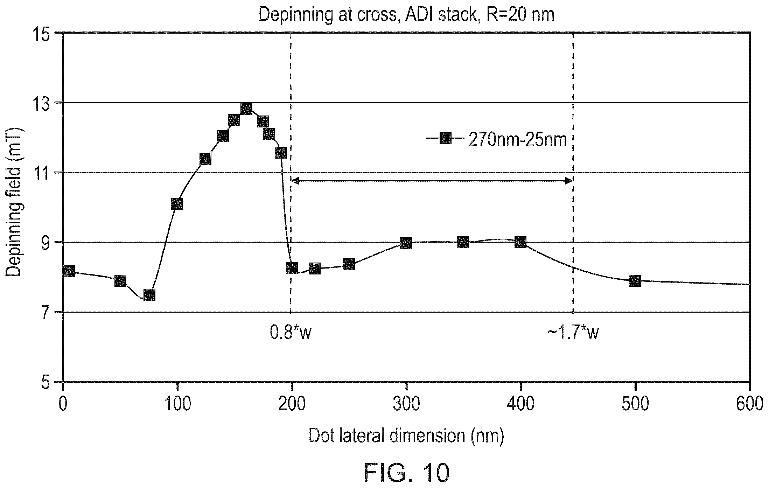

Figure 10 illustrates the impact of increasing the thickness of the free layer on the depinning field, that is, the lower limit of the operating window, Bmin. As can be seen, for area diameters below 0.8w, a relatively large increase in the depinning field, Bmin, is observed. However, the depinning field, Bmin, decreases to an acceptable level if the diameter of the area of increased free layer thickness (i.e., area 56) is increased to above 0.8w. That is to say, for the area diameters where the increase in Bnuc is observed, the depinning field Bmin remains at an acceptable level.

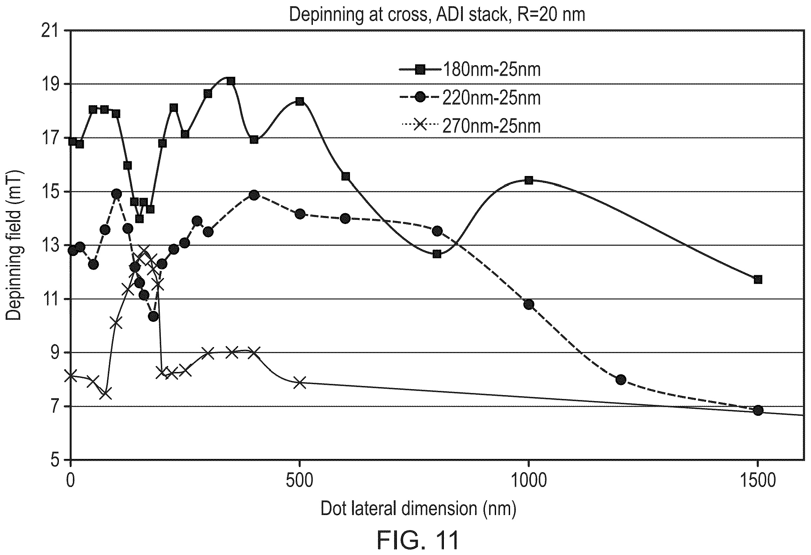

Figure 11 further illustrates the impact of increasing the thickness of the free layer on the depinning field, Bmin. For narrower magnetoresistive tracks (e.g., 180nm and 220nm), variations of around 2mT are observed for areas of increased free layer thickness with smaller diameters (e.g., between 0.8w and 1.7w). For areas of increased free layer thickness with larger diameters (e.g., above 7.5w), a reduction in the Bmin of up to 6mT is observed.

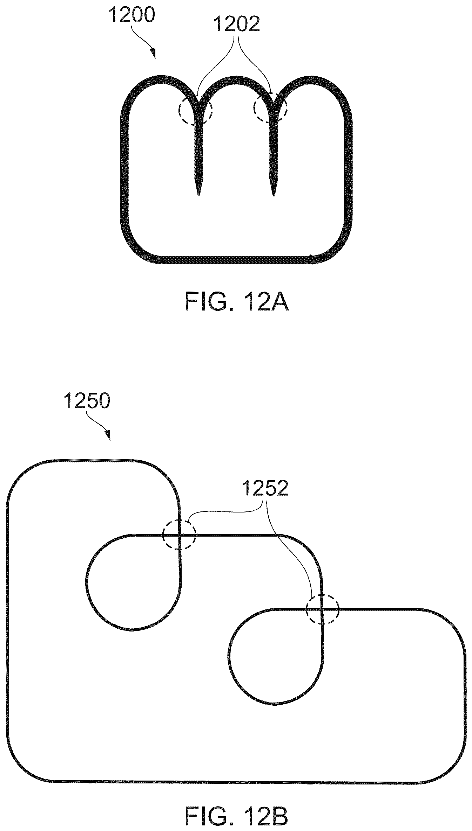

Figures 12A-B illustrate further examples of multi-turn sensors in which one or more regions of increased free layer of thickness may be implemented.

Figure 12A shows a divider type multi-turn sensor 1200, wherein the magnetoresistive track is arranged in a closed loop configuration with a plurality of divider loops. Each of the divider loops include a plurality of 'dead ends' that are proceeded by two curved magnetoresistive tracks meeting to create a "Y" shaped junction (shown generally at 1202). As the domain walls are propagating around the divider type sensor 1200, the domain walls are split into two domain walls (e.g., when they are somewhere along a loop). After one rotation, one of the domain walls will propagate along the dead end and disappear at the tip, whilst the other will be stopped around the Y-junction 1202 and then released after an additional rotation. The number of dead ends and Y-junctions 1202 in the divider type structure thus determines the amount of turns a magnetic field needs to be rotated to get back to the original state.

One of the main problems with this divider structure is the area where two arms of each dividing loops join, i.e., the Y-junction 1202. The width of the magnetoresistive track in the region of the Y- junction track can be up to twice as wide, or at least substantially wider, as the tracks in other areas of sensor 1200. As a result, the shape anisotropy is significantly reduced in this Y-junction area such that domain wall nucleation occurs at lower magnetic fields compared to the other areas of the sensor 1200, which limits the useful magnetic operating window. That is to say, at lower magnetic fields, domain walls will more readily nucleate in these Y-junctions 1202, causing the sensor to operate incorrectly. Therefore, this may be addressed by implementing a region of increased free layer thickness in the Y-junction in order to increase the upper limit of the operating window in that area.

Figure 12B illustrates a further divider type multi-turn sensor 1250, wherein the magnetoresistive track is arranged in a closed loop configuration with a plurality of looped sections. The looped sections comprise a crossing (shown generally at 1252) where the magnetoresistive track crosses over itself. As described with respect to Figures 3B and 3C, it can be difficult to fabricate these crossings without increasing the amount of magnetoresistive material in the region of the crossing 1252, which can result in a decrease in the nucleation field, Bnuc, in this region. As such, this may again be addressed by implementing a region of increased free layer thickness at the crossings 1252 in order to increase the upper limit of the operating window in that area.

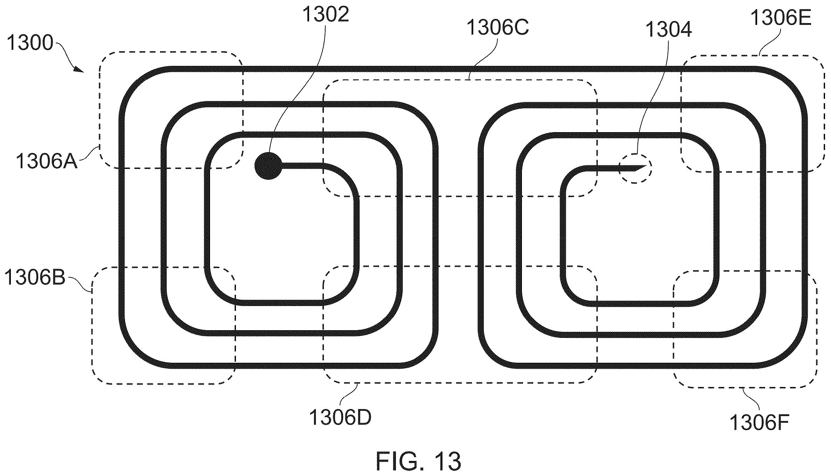

Figure 13 illustrates an example of an open loop multi-turn sensor 1300 in which one or more regions of increased free layer of thickness may be implemented. As shown in Figure 13, the magnetoresistive track is arranged as two spirals connected in series, though it will be appreciated that the magnetoresistive track may also be arranged as a single spiral. The sensor 1300 comprises two ends, a first end comprising a domain wall generator 1302 and a second end with a sharpened tip 1304. The second end may operate as a reference resistor for the rest of the sensor 1300. In use, domain walls are generated by the domain wall generator 1302 and propagate along the magnetoresistive track as an external magnetic field is rotated. As in the examples shown in Figures 1A-B, the straight sections of magnetoresistive track will be provided with a plurality of electrical contacts (not shown) to define a plurality of sensing elements, which can then be connected to a power supply to enable their resistances to be measured.

As will be described in more detail below, domain wall nucleation can more readily occur in sharpened ends of a magnetoresistive track. As such, in cases where the spiral end 1304 it is being used as a reference resistor, a region of increased free layer thickness may be required in order to increase the nucleation field, Bnuc, in this area.

Additionally, the corner regions of the spirals (shown generally at 1306A-F) may experience a lower nucleation field, Bnuc, compared to the straight sections of the spiral, resulting in unwanted domain wall nucleation in these regions. Since the corner regions 1306A-F are typically not used to provide resistance measurements (i.e., these portions do not contribute to the electrical turn count measurement of the sensor), a free-layer of increased thickness may also be implemented in these corner regions 1306A-F to increase the nucleation field, Bnuc, in these areas.

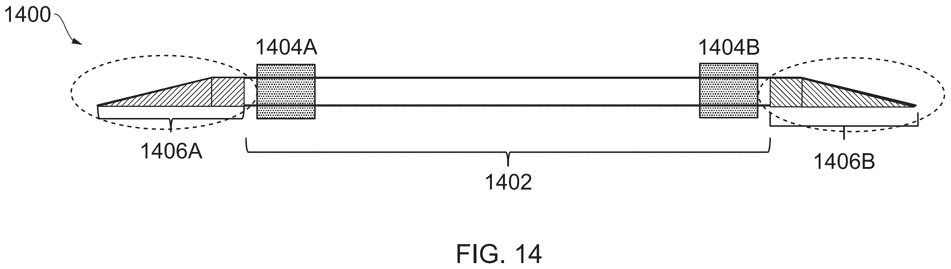

Figure 14 illustrates an example of a reference resistor 1400 in which one or more regions of increased free layer of thickness may be implemented. In this example, the reference resistor 1400 comprises a length of magnetoresistive material 1402, two electrical contacts 1404A-B disposed along the resistor 1400 and end regions 1406A-B with sharpened tips. It will, however, be appreciated that one end of the resistor 1400 may be connected to a sensor spiral such as that shown in Figure 13. The region of magnetoresistive material between the two electrical contacts 1404A-B defines the portion used to provide reference measurements. In such reference resistors 1400, domain wall nucleation can start to occur at lower magnetic fields close to the sharpened tips. As this region is not used for resistance measurement, a free layer of increased thickness may be used in this region to increase the nucleation field. As such, the length of magnetoresistive material shown generally at 1402 may have a free layer with a first thickness, whilst the end regions shown generally at 1406A-B may have a free layer with a second thickness, the second thickness being greater than the first thickness.

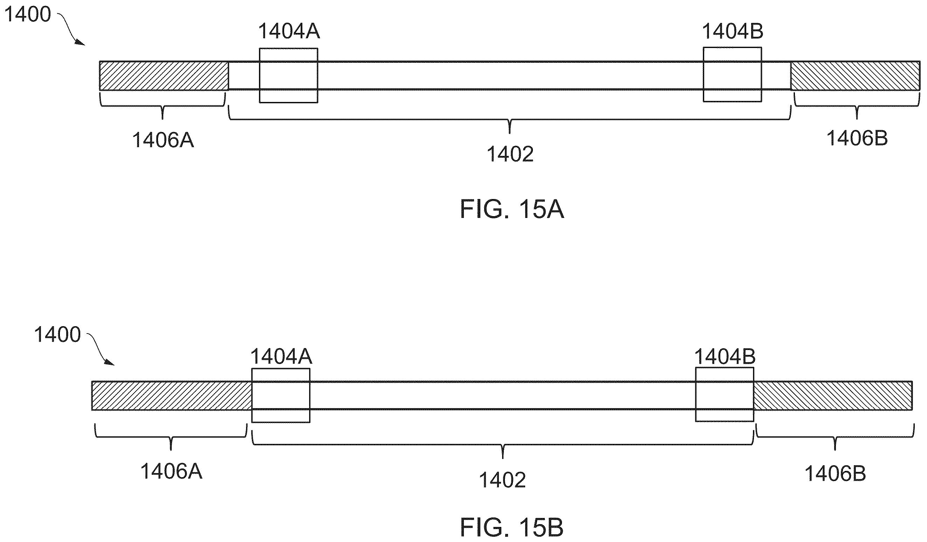

Figures 15A-D illustrate further examples of how the reference resistor 1400 shown in Figure 14 may be formed with an increasing free-layer thickness. Figure 15A shows an example in which the length of magnetoresistive material 1402 having the first free layer thickness extends beyond the electrical contacts 1404A-B, such that the extent of the end regions 1406A-B of increased free layer thickness does not extend up to the contacts 1404A-B. Figure 15B shows an example in which the length of magnetoresistive material 1402 having the first free layer thickness extends up to the outer edge of the electrical contacts 1404A-B, such that the extent of the end regions 1406A-B of increased free layer thickness extends to outer edge of the electrical contacts 1404A-B.

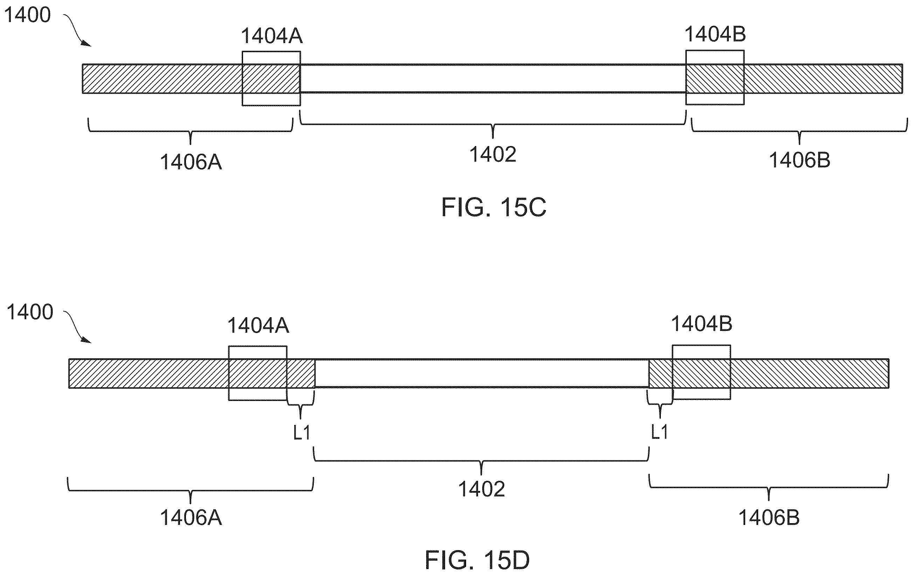

Figure 15C shows an example in which the length of magnetoresistive material 1402 having the first free layer thickness extends up to the inner edge of the electrical contacts 1404A-B, such that the extent of the end regions 1406A-B of increased free layer thickness overlaps with the contact area of the electrical contacts 1404A-B. Extending the region of increased free layer thickness into the contact area may be beneficial to preserve the capping layer in this region, the capping layer being a protection layer that protects the magnetoresistive film when forming the electrical contacts 1404A-B. In this respect, the capping layer may be removed during fabrication in the regions from which measurements are taken (e.g., the length of magnetoresistive material 1402), and thus it may be preferably to extend the region of increased free layer thickness into the contact area to ensure the capping layer is not removed in the areas where the contacts 1404A-B are to be formed.

Figure 15D shows an example in which the end regions 1406A-B of increased free layer thickness extends beyond the contact area of the electrical contacts 1404A-B and extends partially into the resistance measurement region. Whilst the increased free layer thickness in the regions denoted L1 will result in a lower measured resistance change, the impact will be minimal provided the length of L1 is significantly smaller than the length of the magnetoresistive material 1402 having the first free layer thickness.

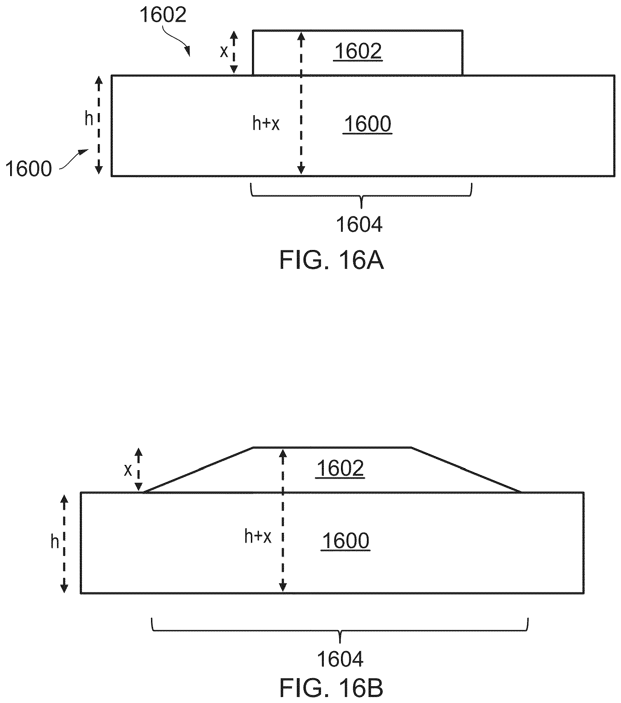

Figures 16A-B illustrate cross-sectional views of a free layer with increased thickness, which may be implemented in the arrangements described herein. Figure 16A shows a cross-sectional view free layer comprising a first portion 1600 having a first thickness, h, and a second portion 1602 having a second thickness, x, to thereby provide a region (shown generally at 1604) having an increased thickness, h+x. The second region 1602 has substantially straight vertical edges, such that there is a step change in thickness of the free layer. However, such an arrangement could result in the edges of the second region 1602 acting as a domain wall pinning or nucleation site, which could affect the operation of the sensor in which the regions of increased thickness are implemented. Therefore, as shown in Figure 16B, it may be beneficial to provide the second of region 1602 with sloped sides, such that there is a gradual change in thickness of the free layer.

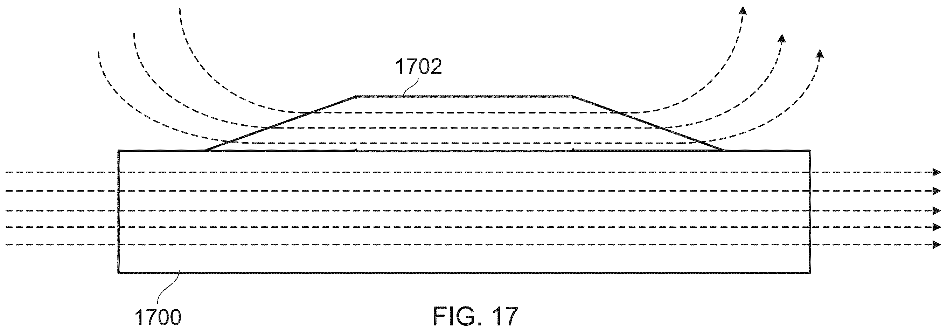

In some cases, it may be necessary to reduce the width of the magnetoresistive film in the regions of increased free layer thickness. Figure 17 shows a cross-section view of a free layer with increased thickness comprising a first portion 1700 having a first thickness and a second portion 1702 having a second thickness, similar to that shown in Figure 16B. The dashed lines illustrate the magnetic flux passing through the free layer. As shown in Figure 17, the magnetic flux within the first portion 100 is contained within the magnetoresistive material, however, stray magnetic fields that come in and out of the magnetoresistive material are created in the region of the second portion 1702, which may in turn create domain wall pinning or nucleation sites in the region of increased thickness.

To compensate for this, localized narrowing of the magnetoresistive track may be provided in the regions of increased free layer thickness so that the overall cross-sectional area of the free layer stays substantially the same, such that all magnetic flux is contained within the magnetoresistive material. In this respect, the ferromagnetic material of the free layer effectively acts as a conductor of magnetic flux, and thus the magnetic flux will stay within the ferromagnetic material if it has the capacity to contain it. The capacity to contain magnetic flux is referred to as the saturation flux density (i.e., how much magnetic flux a material can carry before it becomes saturated), and thus the total magnetic flux contained within the ferromagnetic material will be a product of the area of the material and the saturation flux density. In magnetoresistive tracks, which typically have high aspect ratios, the amount of flux present is assumed to be at the saturation flux density. Therefore, for the regions of increased free layer thickness, the amount total saturation flux will be increased (by virtue of the increased area), unless a narrowing of the tracks is made to ensure that the saturation flux remains the same in all regions of the magnetoresistive track. Conversely, the width of the magnetoresistive track in regions where there is no localized increase in free layer thickness could also be increased to provide the same effect on the overall saturation flux density of the magnetoresistive track.

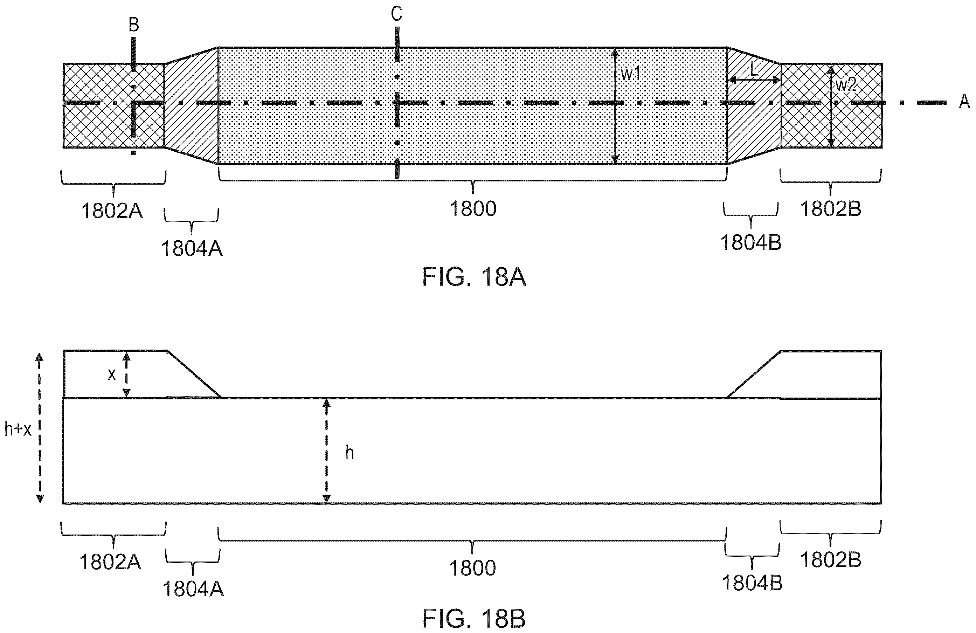

Figures 18A-D illustrate an example in which a section of magnetoresistive track has regions of increased free layer thickness, which are made narrower to minimise the stray magnetic fields generated in those regions. As shown in Figure 18A, the magnetoresistive track has a first region (generally denoted 1800) having a first width, ***w1***, two end regions (generally denoted 1802A, 1802B) having a second width, ***w2*,** which is narrower than the first width, ***w1***. The magnetoresistive track also comprises two transition regions (generally denoted 1804A, 1804B) between the first region and respective end regions, which gradually decreases in width from ***w1*** to **w2** and thickness gradually increases from ***h*** to ***h+x.*** The length, L, of the transition regions 1804A-B will be of the order of multiples of **w1** (e.g., up to 10 times **w1**).

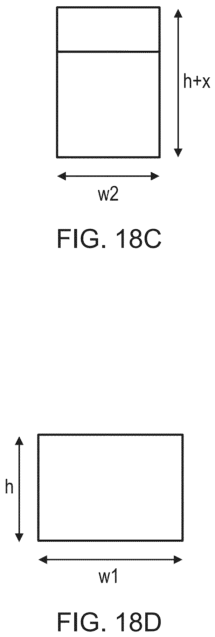

Figure 18B shows a cross-sectional view of the free layer of the magnetoresistive track shown in Figure 18A, along the axis labelled A. As can be seen, the free layer of the first region 1800 has a first thickness, ***h*,** whilst the free layer of the two end regions has a second thickness, ***h*+*x*.** Figure 18C shows a cross-sectional view of the free layer, along the axis labelled B. Similarly, Figure 18D shows a cross-sectional view of the free layer, along the axis labelled C. The width ***w2*** of the end regions 1802A-B with the increased free layer thickness will be selected such that the cross-sectional area shown in Figures 18C-D are substantially constant. That is to say, ***w2**(*h+x*)** is equal to ***w1*h.***

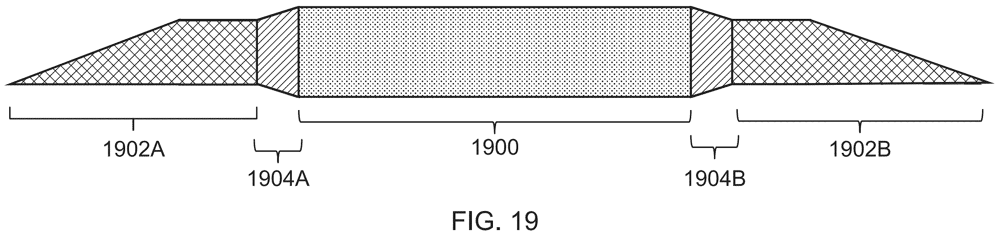

Regions of narrowed track may be applied to any of the arrangements described herein. For example, Figure 19 shows an example of a reference resistor, similar to that shown in Figure 14, wherein the end regions 1902A-B have both an increased free layer thickness and narrowed track width, relative to the resistance measurement region 1900. In some cases, electrical contacts (not shown) may be provided on the transition regions 1904A-B therebetween.

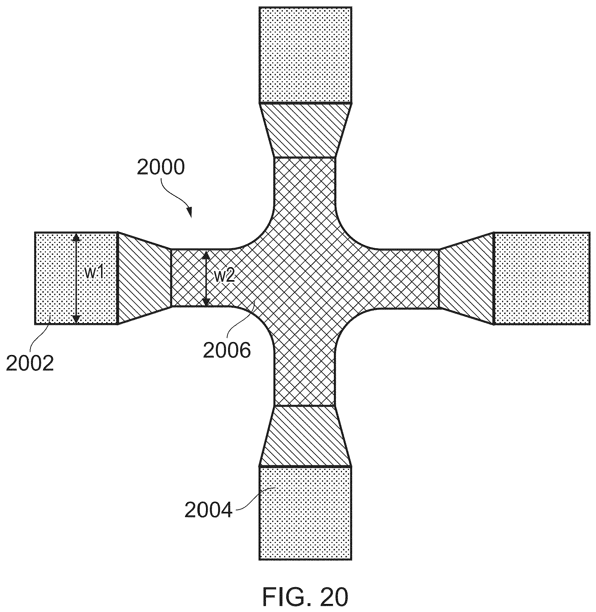

As another example, Figure 20 shows an example of a crossing 2000 in which two sections of magnetoresistive film 2002, 2004 overlap, wherein the central area (shown generally at 2006) of the crossing 2000 has a free layer of increased thickness. In this example, however, the sections of magnetoresistive film 2002, 2004 have a first width, **w1**, but narrow to a second width, **w2,** in the region of the increased free layer thickness.

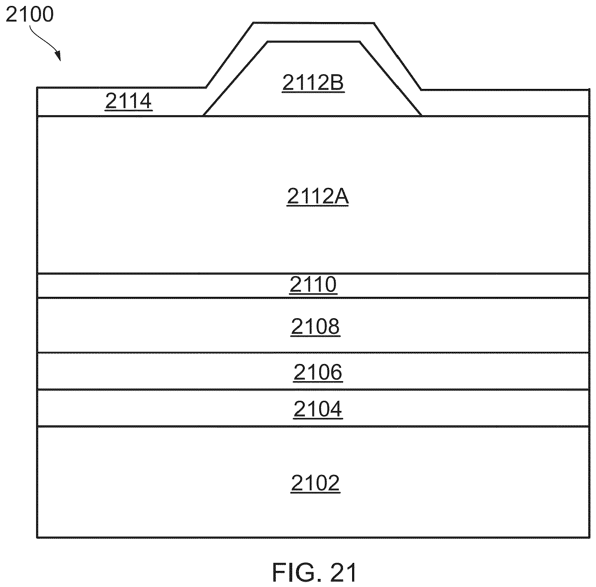

Figure 21 illustrates an example of a "bottom" pinned xMR film 2100 having a localized region of increased free layer thickness. The xMR film 2100 shown in Figure 21 has substantially the same layers as that shown in Figure 4A, namely, a substrate 2102, a further base layer 2104, a seed layer 2106, a SAF layer 2108, a non-magnetic spacer layer 2110, a free layer 2112A and a capping layer 2114. However, in this example, the xMR film 2100 includes an additional portion of free-layer material 2112B arranged on top of the free layer 2112A to provide a region of free layer with increased thickness relative to the rest of the film 2100.

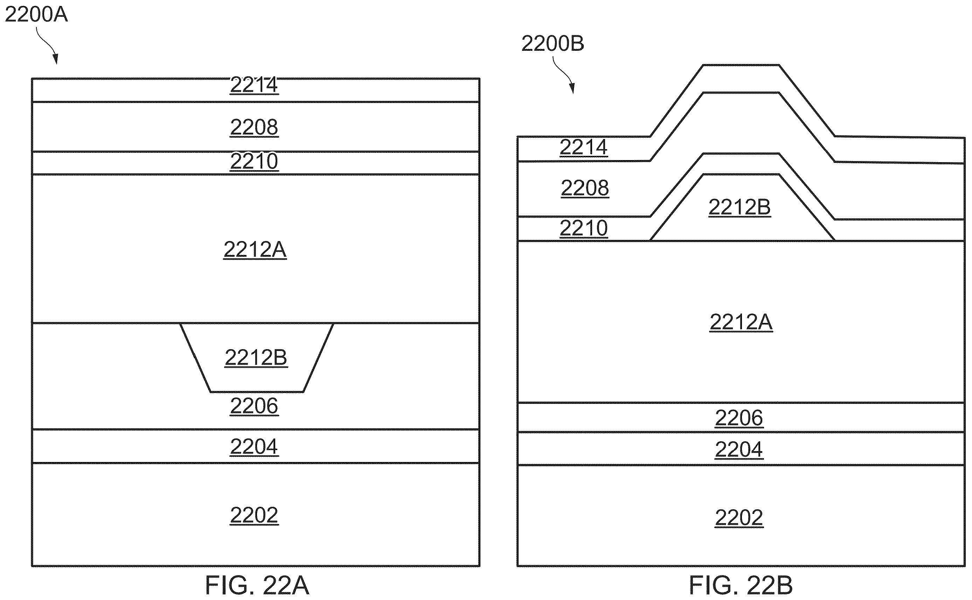

Figures 22A-B illustrate example of a "top" pinned xMR film 2200A-B having a localized region of increased free layer thickness. The xMR film 2200A shown in Figure 22A has substantially the same layers as that shown in Figure 4B, namely, a substrate 2202, a further base layer 2204, a seed layer 2206, a free layer 2212A, a non-magnetic spacer layer 2210, a SAF layer 2208, and a capping layer 2214. However, in this example, the xMR film 2200 includes an additional portion of free-layer material 2212B arranged below the free layer 2212A to provide a region of free layer with increased thickness relative to the rest of the film 2200A. The xMR film 2200B shown in Figure 22B is substantially the same as that shown in Figure 22A, however, in this example, the additional portion of free layer material 2212B is arranged above the free layer 2212B to provide the region of free layer with increased thickness.

Whilst the use of localized regions of increased free layer thickness may be required in certain types of magnetoresistive multi-turn sensors, in particular, giant magnetoresistive (GMR) sensors where the thickness of the free layer can affect the GMR effect (i.e., reduce the measurable change in resistance), it will be appreciated that an increased free layer thickness may be used along the entire length of the magnetoresistive track, including the sections where resistance is measured, in other types of the magnetoresistive multi-turn sensors, such as tunnel magnetoresistive (TMR) sensors. In this respect, electrical contacts are typically arranged on both the top and bottom of the TMR film to measure the current passing through a tunnel barrier layer. This vertical resistance measurement means that a thicker free layer may be implemented without affecting the measurable change in resistance, and thus a free layer of increased thickness may be used throughout the sensor track. In this respect, in a TMR film with vertical current flow, the resistance is typically quite high and dominated by the thickness of the oxide spacer layer. As such, additional layers of material (i.e., additional free layer material) will not have a significant effect since these typically have a much lower vertical resistance relative to the oxide spacer layer.

It will be understood that any suitable method may be used to manufacture a magnetoresistive film with localized regions of increased free layer thickness.

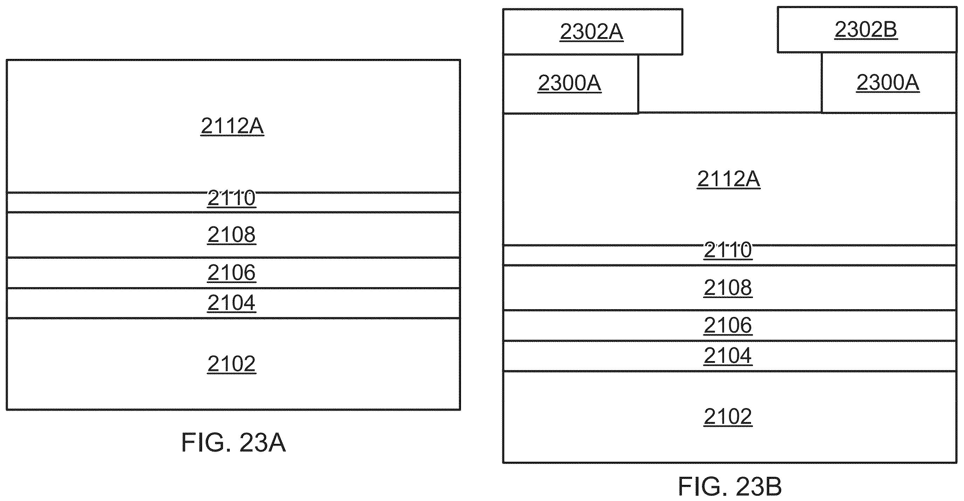

Figures 23A-F illustrate an example of a method of manufacturing a bottom pinned magnetoresistive film with a region of increased free layer thickness such as that shown in Figure 21. It will of course be appreciated that a similar method may also be used to manufacture a top pinned magnetoresistive film with a region of increased free layer thickness such as that shown in Figures 22A-B.

Firstly, as shown in Figure 23A, the seed layer 2106 is deposited onto the base substrate layers 2102, 2104. This is followed by the SAF layer 2108, the spacer layer 2110, and the free layer 2112A.

As shown in Figure 23B, a lift-off layer 2300A-B and a photoresist layer 2302A-B are formed on the free layer 2121A. In the respect, the lift-off layer 2300A-B and photoresist layer 2302A-B are formed everywhere where an increased free-layer thickness is not required. That is to say, the gaps in the lift-off layer 2300A-B and photoresist layer 2302A-B will correspond to the regions where the increased free layer thickness is required. For example, in a closed loop multi-turn sensor, the lift-off layer 2300A-B and photoresist layer 2302A-B may be deposited along the parts of the track corresponding to the sensing elements where resistance will be measured, with the gaps in the lift-off layer 2300A-B and photoresist layer 2302A-B being placed in the regions of the crossings, and other parts (such as corners) where resistance measurements are not made.

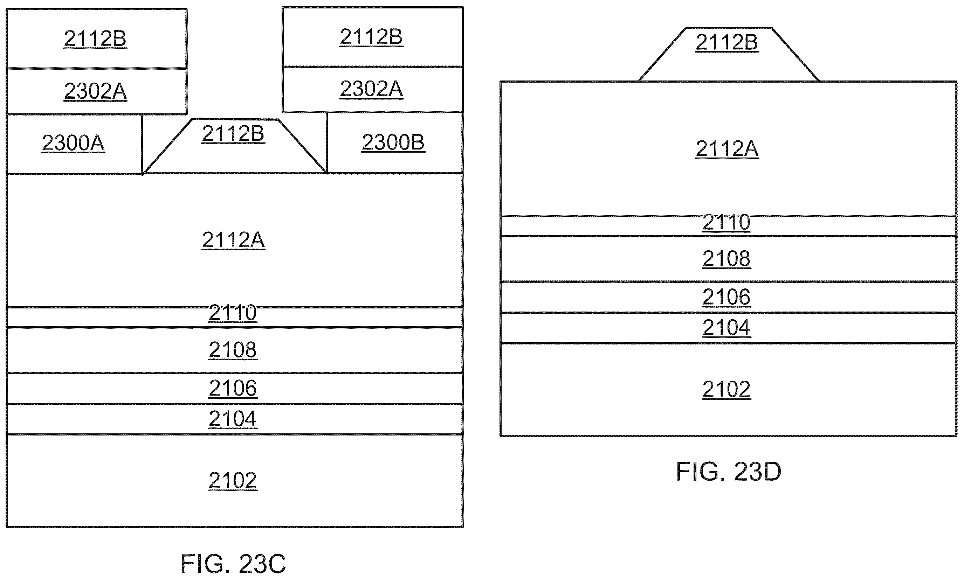

As shown in Figure 23C, a blanket layer of the additional free layer material 2112B is deposited. As shown in Figure 23D, the lift-off layer 2300A-B and photoresist layer 2302A-B are stripped off using any suitable method, such that the additional free layer material 2112B only remains in the regions where increased free layer thickness is required.

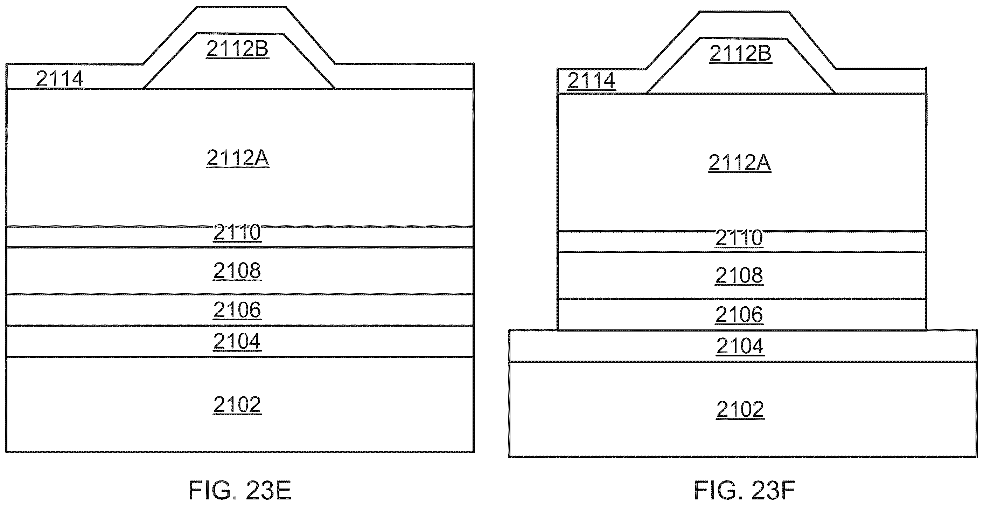

Finally, as shown in Figure 23E, the capping layer 2114 is deposited. As shown in Figure 23F, the magnetoresistive film may then be patterned for example, using a physical etch with a photoresist mask, to thereby form the tracks of the multi-turn sensor. In this respect, Figure 23F may represent a cross-sectional view of the magnetoresistive film in the region of a crossing such as that shown in Figure 5.

Once the tracks of the multi-turn sensor have been patterned, the electrical contacts for connecting the sensor to a power supply with then be formed. In this respect, the electrical contacts may be formed by depositing an insulating barrier layer that is patterned to form one or more openings in which the contacts will be formed. At least one layer of interconnect metal may then be deposited in the openings and patterned to form the electrical contacts, although it will be appreciated that several layers of one or more metals may be used to form the contacts

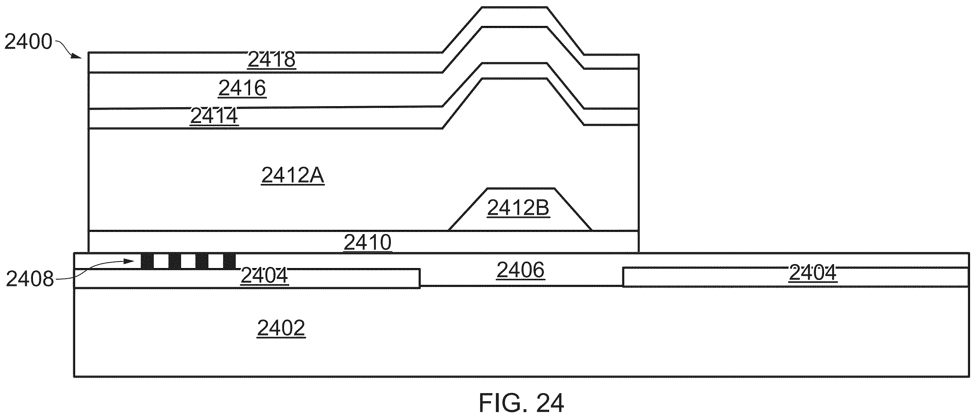

As a further example, the magnetoresistive film may be connected to underlying metal contacts using tungsten plug vias. An example of this using a top pinned magnetoresistive film 2400 is shown in Figure 24. As before the magnetoresistive film 2400 comprises a seed layer 2410, a free layer 2412A, a region of additional free layer material 2412B, a spacer layer 2414, a SAF layer 2416 and a capping layer 2418 is provided. This magnetoresistive film 2400 sits on top of an intermetal dielectric layer 2410, which is deposited on one or more interconnect metal layers 2404 and a substrate layer 2402. Whilst not shown, it will be appreciated that the substrate layer shown generally as 2402 may also consist of further metal layers and other electrical components such as diodes and transistors for controlling the supply of electrical current to the interconnect metal layers 2404. A plurality of tungsten plug vias 2408 are provided in the intermetal dielectric layer 2410 to provide an electrical connection between the magnetoresistive film 2400 and the interconnect metal layers 2404.

Whilst Figure 24 shows the metal contacts 2404, intermetal dielectric layer 2410 and tungsten plug vias 2408 below the magnetoresistive film 2400, it will be appreciated that a similar arrangement may also be provided on top of the magnetoresistive film, for example, in the case of a bottom pinned magnetoresistive film.

As described above, a free layer of increased thickness may not be desirable along the entire length of the magnetoresistive track in GMR sensors due to the effect on the measurable change of resistance in the sensing regions. Another solution to increase the upper limit of the operating window in areas where domain wall pinning/nucleation can more readily occur (such as crossings or sharpened ends), without reducing the measurable change of resistance in the rest of the sensor, is to use a partially insulated free layer.

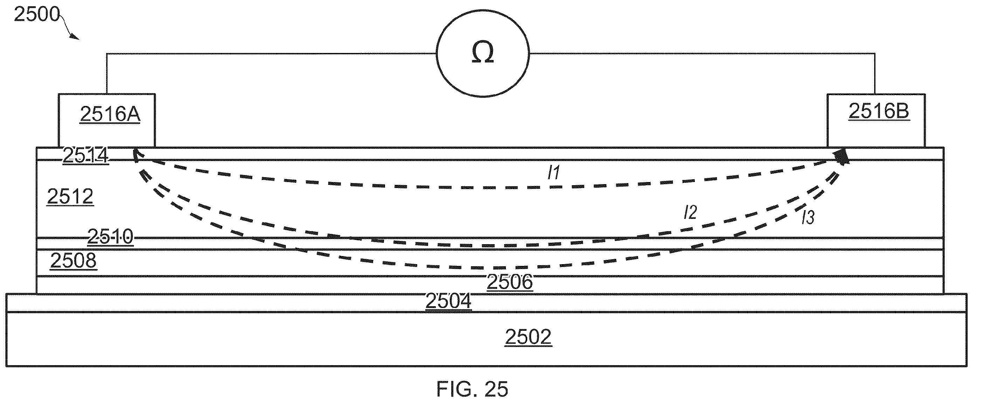

Figure 25 illustrates the current flow in a sensing element of a GMR film 2500 with increased free layer thickness. As shown in Figure 25, the GMR film 2500 comprises a substrate 2502, a further base layer 2504, a seed layer 2506, a SAF layer 2508, a non-magnetic spacer layer 2510, a free layer 2512 of increased thickness and a capping layer 2514. Two metal contacts 2516A-B are provided at two locations along the film 2500 to thereby define a sensing element or region, the contacts 2516A-B being connected to a power supply to thereby enable resistance measurements to be made. As can be seen from Figure 25, most of the current flows through the free layer 2512, relative to the current flowing through the spacer 2510 and the SAF layer 2508. However, the GMR effect (i.e., the change in resistance) is only observed from the current I2 flowing through the entirety of the free layer 2512 and into the spacer layer 2510. As such, the increased thickness of the free layer has a shunting effect on the current flowing through the GMR film 2500, resulting in a reduced measurable change in resistance.

A solution to this problem is to divide the free layer into two or more portions that are separated by an isolation spacer layer, to thereby prevent current from preferentially flowing through the free layer.

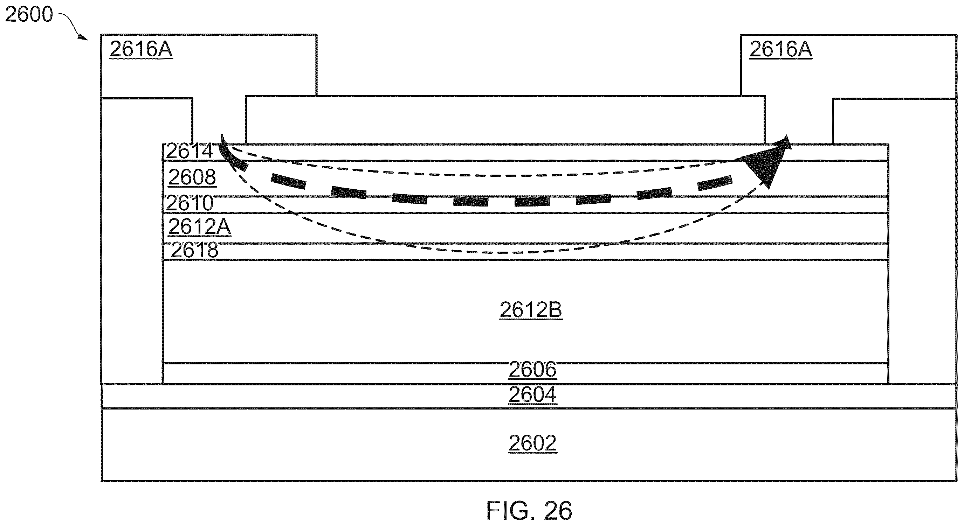

Figure 26 illustrates an example of a top pinned GMR film 2600 in which a thinner portion of the free layer 2612A is separated from a thicker portion of free layer 2612B by a thin isolation spacer layer 2618, the isolation spacer layer 2618 being formed from a non-conductive or high resistance material, such as aluminium oxide or magnesium oxide, or a thin magnetic oxide film such as an iron oxide, ferrite, garnet or perovskite. Magnetic coupling needs to be preserved for the whole free layer 2612A-B to behave as a magnetically uniform free layer, but electrical resistance needs to be increased to prevent the current from preferentially flowing into the portion of free layer 2612B with increased thickness and below the spacer 3610. As such, by isolating a portion of the free layer 2612A using a non-conductive, high resistance isolation spacer layer 2618, this stops any shunting of the current towards the thicker portion of free layer 2612B and ensures that a larger proportion of the current from the contacts 2616A-B flows through the non-magnetic spacer 2610, such that a measurable GMR effect is observed. In cases where a magnetic oxide film is used as the isolation spacer layer 2618, this may be formed through controlled oxidation of the surface of the free layer 2612B during deposition.

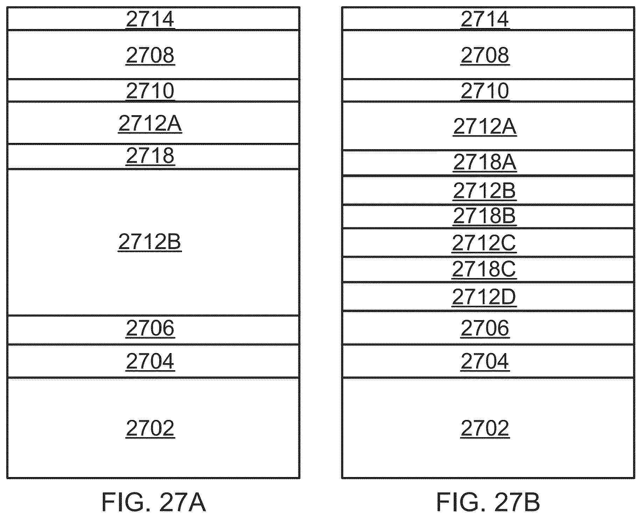

Figures 27A-B further illustrate examples a GMR film comprising an isolation spacer layer. As shown in Figure 27A, the GMR film comprises a substrate 2702, a further base layer 2704, a seed layer 2706, a first portion of free layer material 2712B of increased thickness, an isolation spacer layer 2718, a second, thinner portion of free layer material 2712A, a non-magnetic spacer layer 2710, a SAF layer 2708 and a capping layer 2714. Figure 27B is substantially the same as Figure 27A, however, in this example the portion of free layer material of increased thickness is divided into multiple portions 2712B-D and separated by multiple isolation spacer layers 2718A-C. In this respect, it will be appreciated that multiple layers of free layer material may be used to provide the required increase in magnetic operating window, with multiple isolation spacer layers being used to ensure the shunting effect is reduced sufficiently.

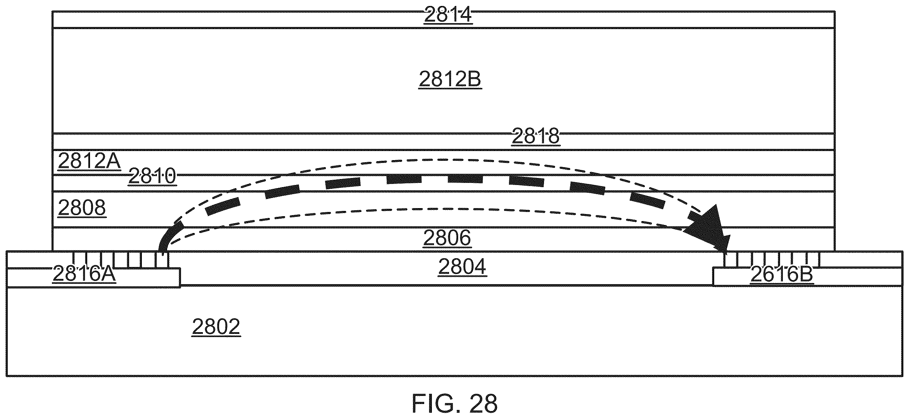

Figure 28 illustrate a bottom pinned GMR film with a similar arrangement for connecting the GMR film as shown in Figure 24. Similar to the top pinned arrangement shown in Figure 26, the GMR film is provided with an isolation spacer layer 2818 between two portions of free layer 2812A-B, to thereby provide an overall free layer of increased thickness, whilst reducing the shunting effect.

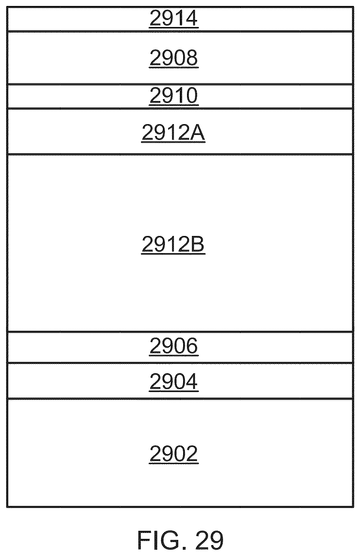

Figure 29 illustrates an alternative GMR film arrangement in which a portion of the free layer is formed from a soft ferromagnetic oxide. As before, the GMR film comprises a substrate 2902, a further base layer 2904, a seed layer 2906, a non-magnetic spacer layer 2910, a SAF layer 2908 and a capping layer 2914. However, in this example the free layer is formed from two layers of different material, a first layer 2912A formed from the usual ferromagnetic material, and a second layer 2912B formed from a soft ferromagnetic oxide. Ferromagnetic oxides are naturally non-conductive and high resistance, and thus the level of shunting into the free layer can be significantly reduced compared to a free layer of increased thickness made entirely from a ferromagnetic metal material. Whilst a top pinned arrangement is shown, it will be appreciated that this may also be applied to a bottom pinned arrangement.

### Applications

Any of the principles and advantages discussed herein can be applied to other systems, not just to the systems described above. Some embodiments can include a subset of features and/or advantages set forth herein. The elements and operations of the various embodiments described above can be combined to provide further embodiments. The acts of the methods discussed herein can be performed in any order as appropriate. Moreover, the acts of the methods discussed herein can be performed serially or in parallel, as appropriate. While circuits are illustrated in particular arrangements, other equivalent arrangements are possible.

Any of the principles and advantages discussed herein can be implemented in connection with any other systems, apparatus, or methods that benefit could from any of the teachings herein. For instance, any of the principles and advantages discussed herein can be implemented in connection with any devices with a need for correcting rotational angle position data derived from rotating magnetic fields. Additionally, the devices can include any magnetoresistance devices capable of sensing magnetic fields.

Aspects of this disclosure can be implemented in various electronic devices or systems. For instance, phase correction methods and sensors implemented in accordance with any of the principles and advantages discussed herein can be included in various electronic devices and/or in various applications. Examples of the electronic devices and applications can include, but are not limited to, servos, robotics, aircraft, submarines, toothbrushes, biomedical sensing devices, and parts of the consumer electronic products such as semiconductor die and/or packaged modules, electronic test equipment, etc. Further, the electronic devices can include unfinished products, including those for industrial, automotive, and/or medical applications.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Thus, although the various schematics shown in the figures depict example arrangements of elements and components, additional intervening elements, devices, features, or components may be present in an actual embodiment (assuming that the functionality of the depicted circuits is not adversely affected). The words "based on" as used herein are generally intended to encompass being "based solely on" and being "based at least partly on." Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values or distances provided herein are intended to include similar values within a measurement error.

While certain embodiments have been described, these embodiments have been presented by way of example only, and are not intended to limit the scope of the disclosure. Indeed, the novel apparatus, systems, and methods described herein may be embodied in a variety of other forms. Furthermore, various omissions, substitutions and changes in the form of the methods and systems described herein may be made without departing from the spirit of the disclosure.

### Numbered aspects

By way of non-limiting example, some aspects of the disclosure are set out in the following numbered clauses.
1. An aspect of the disclosure provides a magnetic multi-turn sensor, comprising:
   a magnetoresistive track arranged in an open or closed loop configuration, the magnetoresistive track comprising a magnetoresistive film,
   wherein the magnetoresistive film comprises at least a free layer of ferromagnetic material; and
   wherein the free layer of ferromagnetic material has at least one region of increased thickness relative to a thickness of the free layer of ferromagnetic material along the length of the magnetoresistive track.
2. A magnetic multi-turn sensor according to a further aspect, wherein the free layer of ferromagnetic material has a magnetisation that is free to align as domain walls propagate with the rotation of an externally applied magnetic field.
3. A magnetic multi-turn sensor according to a further aspect, wherein the at least one region of increased thickness is configured to gradually increase in thickness.
4. A magnetic multi-turn sensor according to a further aspect, wherein the free layer of ferromagnetic material comprises a first layer of ferromagnetic material having a first thickness, and wherein the at least one region of increased thickness further comprises at least a second layer of ferromagnetic material having a second thickness.
5. A magnetic multi-turn sensor according to a further aspect, wherein the second layer of ferromagnetic material comprises a sloped configuration to provide a gradual increase in thickness.
6. A magnetic multi-turn sensor according to a further aspect, wherein the magnetoresistive track is arranged in a closed loop configuration having one or more crossings such that a section of magnetoresistive track overlaps a further section of magnetoresistive track, wherein the free layer of ferromagnetic material has an increased thickness in a region of the one or more crossings.
7. A magnetic multi-turn sensor according to a further aspect, wherein the region of increased thickness of the free layer of ferromagnetic material in the region of the one or more crossings extends partially along the sections of the magnetoresistive track defining each crossing.
8. A magnetic multi-turn sensor according to a further aspect, wherein the region of increased thickness of the free layer of ferromagnetic material in the region of the one or more crossings has a diameter of about 0.8 times the width of the magnetoresistive track up to about 1.7 times the width of the magnetoresistive track, or a diameter above about 7.5 times the width of the magnetoresistive track.
9. A magnetic multi-turn sensor according to a further aspect, wherein the magnetoresistive track is arranged in a closed loop configuration having a plurality of divider loops along at least one side of the closed loop configuration, each of the plurality of divider loops comprising a Y-shaped junction, wherein the free layer of ferromagnetic material has an increased thickness in a region of the Y-shaped junction.
10. A magnetic multi-turn sensor according to a further aspect, wherein the magnetoresistive track is arranged in a spiral configuration having a plurality of corner regions, wherein the free layer of ferromagnetic material has an increased thickness in the plurality of corner regions.
11. A magnetic multi-turn sensor according to a further aspect, wherein the magnetoresistive track is arranged in an open loop configuration having a first end and a second end, wherein the second end is configured to provide a reference resistor, and wherein the free layer of ferromagnetic material has an increased thickness in a region of the second end.
12. A magnetic multi-turn sensor according to a further aspect, wherein magnetoresistive track has a first width, and the magnetoresistive track in the at least one region of increased thickness has a second width, the second width being smaller than the first width.
13. A magnetic multi-turn sensor according to a further aspect, wherein the magnetoresistive film is a giant magnetoresistive (GMR) film or tunnel magnetoresistive (TMR) film.
14. An aspect of the disclosure provides a reference resistor, comprising:
   a length of magnetoresistive film having a first end and a second end, the first and second ends having a sharpened configuration;
   a pair of electrical contacts arranged along the length of the magnetoresistive film to define a portion of the magnetoresistive film across which resistance is to be measured;
   wherein the magnetoresistive film comprises at least a free layer of ferromagnetic material, the free layer of ferromagnetic material having an increased thickness in a region of the first and second ends relative to a thickness of the free layer of ferromagnetic material along the length of the magnetoresistive film.
15. A reference resistor according to a further aspect, wherein the regions of increased thickness extend from each respective end up to an outer edge of the pair of electrical contacts.
16. A reference resistor according to a further aspect, wherein the regions of increased thickness extend from each respective end up to an inner edge of the pair of electrical contacts.
17. A reference resistor according to a further aspect, wherein the regions of increased thickness extend from each respective end and partially beyond the pair of electrical contacts.
18. A reference resistor according to a further aspect, wherein the portion of the magnetoresistive film between the pair of electrical contacts has a first width, and the first and second end regions of the magnetoresistive film have a second width, the second width being smaller than the first width.
19. A reference resistor according to a further aspect, wherein the free layer of ferromagnetic material has a magnetisation that is free to align as domain walls propagate with the rotation of an externally applied magnetic field.
20. A reference resistor according to a further aspect, wherein the magnetoresistive film is a giant magnetoresistive (GMR) film or tunnel magnetoresistive (TMR) film.
21. A further aspect of the disclosure provides a method of manufacturing a magnetic multi-turn sensor, the method comprising:
   providing a magnetoresistive film on a substrate, wherein the magnetoresistive film comprises at least a free layer of ferromagnetic material, wherein the free layer of ferromagnetic material comprises at least one region of increased thickness; and
   patterning the magnetoresistive film to form a magnetoresistive track arranged in an open or closed loop configuration, the magnetoresistive track comprising the at least one region of increased thickness.
22. A method of manufacturing a magnetic multi-turn sensor according to a further aspect, further comprising forming the at least one region of increased thickness such that it gradually increases in thickness.
23. A method of manufacturing a magnetic multi-turn sensor according to a further aspect, wherein providing the magnetoresistive film comprises:
   depositing a first layer of ferromagnetic material having a first thickness; and
   depositing, on one or more regions of the first layer of ferromagnetic material, a second layer of ferromagnetic material having a second thickness to thereby provide the at least one region of increased thickness.
24. A method of manufacturing a magnetic multi-turn sensor according to a further aspect, wherein providing the magnetoresistive film further comprises patterning the second layer of ferromagnetic material to have a sloped configuration to thereby provide a gradual increase in thickness.
25. A further aspect of the disclosure provides a magnetic multi-turn sensor, comprising:
   a magnetoresistive track arranged in an open or closed loop configuration, the magnetoresistive track comprising a magnetoresistive film, wherein the magnetoresistive film comprises at least a free layer of ferromagnetic material; and
   wherein the free layer of ferromagnetic material comprises at least two layers of ferromagnetic material, wherein at least one spacer layer is provided between the layers of ferromagnetic material.
26. A magnetic multi-turn sensor according to a further aspect, wherein the at least one spacer layer comprises a non-conductive or high resistance material.
27. A magnetic multi-turn sensor according to a further aspect, wherein the at least one spacer layer comprises a magnetic oxide or metal oxide material.
28. A magnetic multi-turn sensor according to a further aspect, wherein the at least one spacer layer comprises one of: aluminium oxide, magnesium oxide, iron oxide, ferrite, garnet or perovskite.
29. A magnetic multi-turn sensor according to a further aspect, wherein the at least two layers of ferromagnetic material comprise a first layer of ferromagnetic material having a first thickness and a second layer of ferromagnetic material having a second thickness, the second thickness being smaller than the first thickness, and wherein the at least one spacer layer comprises a first spacer layer provided between the first layer and second layer of ferromagnetic material.
30. A magnetic multi-turn sensor according to a further aspect, wherein the magnetoresistive film further comprises:
   a reference layer having a magnetization that is in a fixed direction; and
   a second spacer layer, wherein the second spacer layer is arranged between the reference layer and the second layer of ferromagnetic material.
31. A magnetic multi-turn sensor according to a further aspect, wherein the second spacer layer comprises a non-magnetic material.
32. A magnetic multi-turn sensor according to a further aspect, wherein the at least two layers of ferromagnetic material comprise a plurality of layers of ferromagnetic material, and wherein the at least one spacer layer comprises a plurality of spacer layers provided between the plurality of layers of ferromagnetic material.
33. A magnetic multi-turn sensor according to a further aspect, wherein the plurality of spacer layers comprise a magnetic oxide or metal oxide material.
34. A magnetic multi-turn sensor according to a further aspect, wherein the plurality of spacer layers comprises one of: aluminium oxide, magnesium oxide, iron oxide, ferrite, garnet or perovskite.
35. A magnetic multi-turn sensor according to a further aspect, wherein the magnetoresistive film further comprises:
   a reference layer having a magnetization that is in a fixed direction; and
   a further spacer layer, wherein the further spacer layer is arranged between the reference layer and one of the plurality of layers of ferromagnetic material.
36. A magnetic multi-turn sensor according to a further aspect, wherein the further spacer layer comprises a non-magnetic material.

## Claims

1. A magnetic multi-turn sensor, comprising:
a magnetoresistive track arranged in an open or closed loop configuration, the magnetoresistive track comprising a magnetoresistive film,
wherein the magnetoresistive film comprises at least a free layer of ferromagnetic material; and
wherein the free layer of ferromagnetic material has at least one region of increased thickness relative to a thickness of the free layer of ferromagnetic material along the length of the magnetoresistive track.

2. The magnetic multi-turn sensor according to claim 1, wherein the free layer of ferromagnetic material has a magnetisation that is free to align as domain walls propagate with the rotation of an externally applied magnetic field.

3. The magnetic multi-turn sensor according to claim 1 or 2, wherein the at least one region of increased thickness is configured to gradually increase in thickness.

4. The magnetic multi-turn sensor according to any preceding claim, wherein the free layer of ferromagnetic material comprises a first layer of ferromagnetic material having a first thickness, and wherein the at least one region of increased thickness further comprises at least a second layer of ferromagnetic material having a second thickness, optionally wherein the second layer of ferromagnetic material comprises a sloped configuration to provide a gradual increase in thickness.

5. The magnetic multi-turn sensor according to any preceding claim, wherein the magnetoresistive track is arranged in a closed loop configuration having one or more crossings such that a section of magnetoresistive track overlaps a further section of magnetoresistive track, wherein the free layer of ferromagnetic material has an increased thickness in a region of the one or more crossings, optionally wherein the region of increased thickness of the free layer of ferromagnetic material in the region of the one or more crossings extends partially along the sections of the magnetoresistive track defining each crossing, optionally wherein the region of increased thickness of the free layer of ferromagnetic material in the region of the one or more crossings has a diameter of about 0.8 times the width of the magnetoresistive track up to about 1.7 times the width of the magnetoresistive track, or a diameter above about 7.5 times the width of the magnetoresistive track.

6. The magnetic multi-turn sensor according to any preceding claim, wherein the magnetoresistive track is arranged in a closed loop configuration having a plurality of divider loops along at least one side of the closed loop configuration, each of the plurality of divider loops comprising a Y-shaped junction, wherein the free layer of ferromagnetic material has an increased thickness in a region of the Y-shaped junction
and/or
wherein the magnetoresistive track is arranged in a spiral configuration having a plurality of corner regions, wherein the free layer of ferromagnetic material has an increased thickness in the plurality of corner regions
and/or
wherein the magnetoresistive track is arranged in an open loop configuration having a first end and a second end, wherein the second end is configured to provide a reference resistor, and wherein the free layer of ferromagnetic material has an increased thickness in a region of the second end.

7. The magnetic multi-turn sensor according to any preceding claim, wherein magnetoresistive track has a first width, and the magnetoresistive track in the at least one region of increased thickness has a second width, the second width being smaller than the first width.

8. A reference resistor, comprising:
a length of magnetoresistive film having a first end and a second end, the first and second ends having a sharpened configuration;
a pair of electrical contacts arranged along the length of the magnetoresistive film to define a portion of the magnetoresistive film across which resistance is to be measured;
wherein the magnetoresistive film comprises at least a free layer of ferromagnetic material, the free layer of ferromagnetic material having an increased thickness in a region of the first and second ends relative to a thickness of the free layer of ferromagnetic material along the length of the magnetoresistive film.

9. The reference resistor according to claim 8, wherein the regions of increased thickness extend from each respective end up to an outer edge of the pair of electrical contacts
and/or
wherein the regions of increased thickness extend from each respective end up to an inner edge of the pair of electrical contacts
and/or
wherein the regions of increased thickness extend from each respective end and partially beyond the pair of electrical contacts.

10. The reference resistor according to claim 8 or 9, wherein the portion of the magnetoresistive film between the pair of electrical contacts has a first width, and the first and second end regions of the magnetoresistive film have a second width, the second width being smaller than the first width.

11. The reference resistor according to any of claims 8 to 10, wherein the free layer of ferromagnetic material has a magnetisation that is free to align as domain walls propagate with the rotation of an externally applied magnetic field.

12. The magnetic multi-turn sensor or reference resistor according to any preceding claim, wherein the magnetoresistive film is a giant magnetoresistive (GMR) film or tunnel magnetoresistive (TMR) film.

13. A method of manufacturing a magnetic multi-turn sensor, the method comprising:
providing a magnetoresistive film on a substrate, wherein the magnetoresistive film comprises at least a free layer of ferromagnetic material, wherein the free layer of ferromagnetic material comprises at least one region of increased thickness; and
patterning the magnetoresistive film to form a magnetoresistive track arranged in an open or closed loop configuration, the magnetoresistive track comprising the at least one region of increased thickness.

14. The method of manufacturing a magnetic multi-turn sensor according to claim 13, further comprising forming the at least one region of increased thickness such that it gradually increases in thickness.

15. The method of manufacturing a magnetic multi-turn sensor according to claim 13 or 14, wherein providing the magnetoresistive film comprises:
depositing a first layer of ferromagnetic material having a first thickness; and
depositing, on one or more regions of the first layer of ferromagnetic material, a second layer of ferromagnetic material having a second thickness to thereby provide the at least one region of increased thickness, optionally wherein providing the magnetoresistive film further comprises patterning the second layer of ferromagnetic material to have a sloped configuration to thereby provide a gradual increase in thickness.
